# FASCICULE DE BREVET EUROPEEN

(11) **EP 1 835 541 B1**
(45) Date de publication et mention de la délivrance du brevet: **08.11.2017**
(21) Numéro de dépôt: 07005263.4
(22) Date de dépôt: 14.03.2007
(51) Int. Cl.: H01L 27/32, H01L 27/15

(54) **Ensemble de sources lumineuses et dispositif d'affichage pourvu d'au moins un tel ensemble**
Anordnung von mehreren Lichtquellen und Anzeigevorrichtung, die mit einer solchen Anordnung ausgestattet ist
Series of light sources and display device equipped with at least one such series

(30) Priorité: 14.03.2006 FR 0650857
(43) Date de publication de la demande: 19.09.2007
(73) Titulaire: Lamrani, Nordine, 30000 Nimes (FR)
(72) Inventeur: Lamrani, Nordine, 34000 Montpellier (FR)

(56) Documents cités:
- EP-A- 1 517 376
- EP-A2- 0 831 451
- EP-A2- 1 473 690
- JP-A- 2 173 783
- JP-A- 2 181 726
- US-A1- 2002 070 909
- US-A1- 2004 113 875

## Description

La présente invention entre dans le domaine de l'affichage et de la restitution d'image et concerne plus particulièrement des dispositifs d'affichage, de type écran à diodes électroluminescentes.

Une application préférentielle mais non limitative de l'invention consiste à des écrans de grande taille. Un tel écran est employé pour reproduire un visuel fixe ou animé sur une surface de plusieurs mètres carrés afin qu'il soit visible à grande distance par un grand nombre de personnes. Ce type d'affichage trouvera une application préférentielle, mais non limitative, lors d'événementiels, rencontres sportives, communication urbaine, etc.

Tout d'abord, il convient de rappeler que l'affichage d'une image sur un écran consiste à reproduire les couleurs constituant la dite image. L'image est interprétée comme un ensemble de pixels, chaque pixel définissant alors un point de l'image. L'écran reproduit alors chaque pixel pour reconstituer ladite image. Pour ce faire, l'écran est constitué d'une matrice de pixels indépendamment commandés.

Un problème réside dans la restitution la plus fidèle possible de l'image au travers de ces écrans.

L'état de la technique comprend différents types de dispositif d'affichage, mais l'invention vise plus spécifiquement tout type d'écrans, notamment à diodes électroluminescentes, dites LED. Un écran comprend une matrice de pixels, chaque pixel étant restitué par un ensemble de LED.

Les documents EP 1 473 690 A2, EP 0 831 451 A2, US 2004/113875 A1, JP 2 173783 A, EP 1 517 376 A, JP 2 181726 A et US 2002/070909 A1 divulguent des ensembles de sources lumineuses du type LED.

De manière connue et comme veulent le représenter les figures A et B du dessin joint en annexe, les écrans géants existants sont pourvus de pixels représentés par au moins trois LED toujours trois couleurs différentes, rouge, vert et bleue, et aptes, par combinaison, à reproduire une gamme de couleurs dans le spectre visible. Chacune des trois LED représente donc une composante du spectre lumineux selon le principe de codage de couleur dit « RVB ».

Pour tous les écrans, les trois sources lumineuses RVB S1, S2, S3 sont disposées pour former un pixel (dont C est le centre) selon tout type de configuration, en particulier selon un ensemble E triangulaire, comme visible sur l'exemple de la figure A. l'écran est alors constitué d'une matrice M d'ensembles E de LED.

Cette disposition des LED permet d'obtenir un spectre lumineux conforme, comme visible sur la figure B, au· diagramme de l'observateur de Référence exposé en 1931 par la Commission Internationale de l'éclairage et dit « CIE 1931 ».

En fait, l'oeil humain analyse davantage de nuances de couleurs dans la zone P situées à l'intersection des spectres lumineux des trois sources de lumières que dans une zone P'.

De ce constat, l'invention tente de pallier l'inconvénient de l'état de la technique en proposant un dispositif d'affichage restituant plus efficacement les couleurs du spectre lumineux par rapport à l'interprétation qui en est faite par l'oeil humain. L'invention propose une répartition différente des couleurs créées, plus proche de la perception de l'oeil humain.

L'invention réside dans l'utilisation de la quadrichromie au travers de l'ajout, dans une structure particulière, d'une quatrième source lumineuse dans l'ensemble déjà présent de sources lumineuses et destinée à reproduire un pixel. En effet, l'utilisation de la quadrichromie, par insertion d'une source lumineuse supplémentaire, choisie de couleur blanche, et l'adoption d'une architecture appropriée permettent de créer de nouvelles couleurs avec une résolution augmentée au travers d'une luminosité et une définition de ces couleurs améliorées. En somme, il en résulte une optimisation du rendu des couleurs conformément à la perception de l'oeil. Par conséquent, l'étalonnement des nuances de couleurs est recentré autour de la zone P, zone où l'oeil détient le plus de sensibilité aux différentes nuances. Le rendu des couleurs est donc plus fidèle et ces dernières sont plus lumineuses.

De plus, en utilisant une source lumineuse de couleur blanche, le blanc de référence est réalisé de manière stable et homogène. Cette source lumineuse est préférentiellement une diode électroluminescente.

L'invention concerne donc un ensemble de sources lumineuses, notamment de diodes électroluminescentes pour l'affichage d'au moins un pixel au sein d'une matrice.

L'invention concerne aussi un dispositif d'affichage comprenant une matrice de pixels constituée d'une juxtaposition de tels ensembles.

L'invention sera mieux comprise à la lecture de la description qui va suivre se rapportant à un exemple de réalisation et dont la compréhension sera facilitée en se référant au dessin en annexe :
- les figures A et B représentent des structures de pixels d'écrans connus selon l'état de la technique ;
- la figure 1 représente plusieurs ensembles de sources lumineuses juxtaposés de manière à former une matrice d'affichage selon l'invention ;
- la figure 2 est une représentation similaire à la figure 1 illustrant l'appartenance d'une source à douze ensembles de sources différentes.

La présente invention concerne l'affichage d'image, fixe ou animée, sur un support vidéo, en particulier de type écran.

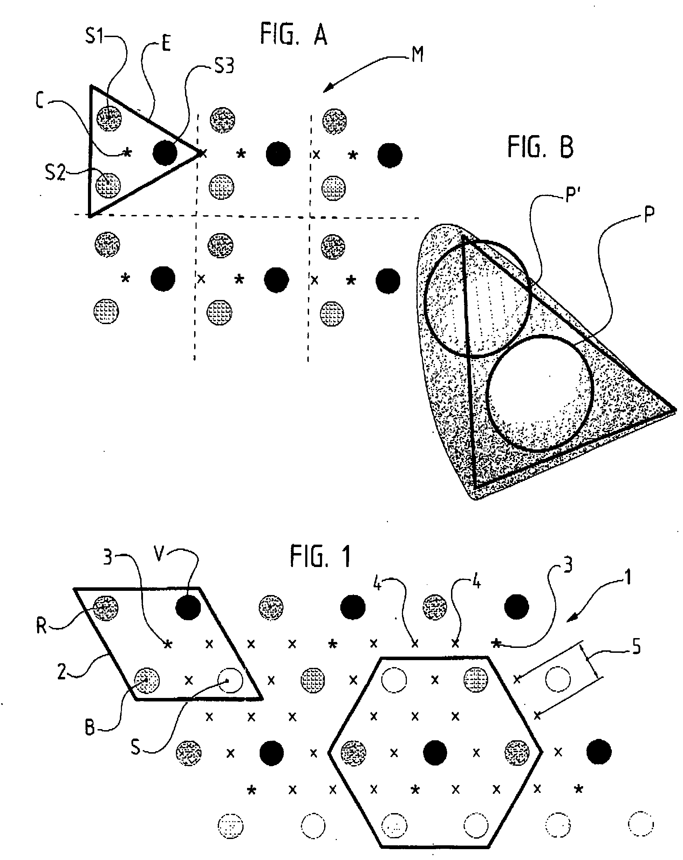

Tel que représenté dans la figure 1, un tel écran comprend une matrice 1 de pixels définissant ladite image, ladite matrice 1 étant constituée par une juxtaposition d'ensembles 2 de sources lumineuses, préférentiellement sous forme de diodes électroluminescentes, dites LED. Avantageusement, cette juxtaposition est prévue uniforme.

Ces sources lumineuses ainsi juxtaposées forment un écran à LED, écran qui peut être prévu de grande taille.

Afin d'améliorer la qualité d'affichage de l'image au travers d'une résolution améliorée et une augmentation du nombre des couleurs, une caractéristique de l'invention consiste en ce qu'un ensemble 2 comprenne au moins quatre sources lumineuses toutes différentes. En effet, un ensemble 2 comprend alors trois sources R, V, B de couleurs et une source lumineuse supplémentaire S. Les sources R, V, B sont de couleur rouge, vert et bleu, étant aptes à reproduire par combinaison tout ou partie du spectre lumineux. En d'autres termes, l'éclairage combiné desdites sources lumineuses, seules ou en combinaison les unes aux autres, permet d'afficher au moins en partie les nuances de couleurs du spectre visible.

L'ajout d'une composante lumineuse blanche, combiné, selon l'invention, à une structure particulière, exposée plus en avant dans la description, permet d'augmenter, par rapport à la sensibilité de l'oeil, le nombre des couleurs et la luminosité de l'image reproduite.

Plus particulièrement, pour un même nombre de couleurs, l'invention propose beaucoup plus de nuances dans la région P où l'oeil est le plus sensible sur cet afficheur.

Tout d'abord en ce qui concerne cette source S, elle est de couleur blanche pour restituer une couleur blanche uniforme. Ainsi, la qualité de rendu est améliorée pour chaque pixel simulé, constitué de tout ensemble 2 de quatre sources R, V, B et S, d'une part, en raison de la luminosité accrue conférée par la source S et, d'autre part, au travers du ciblage de l'échantillonnage des nuances et couleurs au niveau de la zone la plus sensible de perception de l'oeil humain.

De surcroît, une source lumineuse S de couleur blanche peut produire une lumière pouvant avoir un spectre complexe proche de la lumière du jour. La combinaison des spectres des sources R, V, B et du spectre de la source supplémentaire S s'adapte donc d'autant mieux aux récepteurs de l'oeil humain.

Selon l'invention, ces quatre sources R, V, B, S sont réparties de manière à former un losange de sorte qu'au moins une source lumineuse d'un ensemble 2 est équidistante de six autres sources de couleurs complémentaires appartenant audit ensemble 2 ainsi qu'aux ensembles 2 qui le jouxtent. Cette mise en oeuvre particulière dans l'espace permet d'augmenter le nombre de pixels simulés par la matrice 1 et, par conséquent la résolution de l'image, obtenant une meilleure définition de celle-ci.

De manière connue, un pixel, modélisé par son centre 3, est simulé au centre de chaque ensemble 2 de sources lumineuses R, V, B, S. Du fait de la présence de la source supplémentaire S, l'invention permet d'améliorer le rendu du pixel simulé par un ensemble 2 de sources.

En effet, la disposition particulière des sources permet d'augmenter le nombre de pixels simulés.

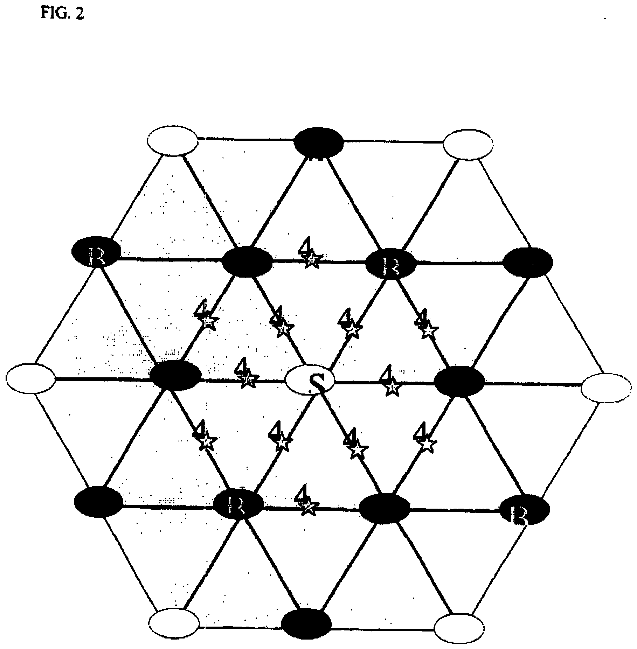

Dans un ensemble de structure carrée une même source lumineuse fait partie de quatre ensembles différents et un pixel modélisé par son centre est alors créé entre chaque ensemble contigu, horizontalement, verticalement ou en diagonal. Chaque source est éclairée de manière à simuler un pixel avec chaque source adjacente. Lesdits pixels simulés sont situés à la demi distance entre deux sources juxtaposées. Si dans le cas d'un ensemble organisé en carré, le nombre de pixel peut être multiplié par quatre, dans une configuration en losange des ensembles 2, visible sur la figure 1 et la figure 2, il est avantageusement multiplié par six. Chaque source se retrouve alors au centre d'un hexagone. Par conséquent, la résolution de l'image, qui doit être affichée, est, elle aussi, accrue.

Ainsi, selon l'invention représentée schématiquement dans les figures 1 et 2, les ensembles 2 sont avantageusement disposés de sorte que chaque source lumineuse d'un ensemble 2 est équidistante de six autres sources de couleurs complémentaires appartenant audit ensemble 2, ainsi qu'aux ensembles 2 qui le jouxtent. Le pitch 5, soit la distance entre deux pixels simulés, est égal à la demi distance entre deux sources lumineuses.

Sur la figure 2, la source S peut être interprétée comme appartenant au pixel « S, R1, V1, B1 » ou « S, R1, V1, B2 » ou « S, R1, V2, B2 » ou « S, R2, V2, B2 » ou « S, R2, V2, B1 » ou « S, R2, V1, B1 » ou « S, R1, V1, B4 » ou « S, R1, V4, B2 » ou « S, R4, V2, B2 » ou « S, R2, V2, B3 » ou « S, R2, V3, B1 » ou « S, R3, V1, B1 », soit sur douze ensembles 2 différents. Cette architecture hexagonale en quadrichromie est parfaitement symétrique et peut être répétée indéfiniment. Elle permet une forte multiplication de la définition de l'image en mode simulation.

Avantageusement, la configuration selon l'invention peut être exploitée dans tout autre domaine. Ainsi, l'invention trouvera une utilisation toute particulière dans le réglage d'une lumière blanche de manière précise dans le domaine de la photographie, du cinéma ou autre. De manière similaire à l'invention, on complète la lumière émise par la source lumineuse blanche par des variations de vert, rouge, bleu afin d'atteindre la température de couleur souhaitée.

## Revendications

1. Ensemble (2) de sources lumineuses pour l'affichage d'au moins un pixel au sein d'une matrice (1), comprenant, d'une part, trois sources lumineuses de couleurs rouge (R), vert (V) et bleu (B) aptes à reproduire par combinaison tout ou partie du spectre lumineux et, d'autre part, une source lumineuse supplémentaire (S) de couleur blanche apte à restituer une couleur blanche uniforme et à compléter le spectre des couleurs crées tout en augmentant la luminosité, les quatre sources lumineuses (R, V, B, S) étant réparties de sorte qu'au moins une source (R, V, B ou S) d'un ensemble (2) est équidistante de six autres sources appartenant audit ensemble (2) ainsi qu'aux ensembles (2) qui le jouxtent, **caractérisé par le fait que** lesdites quatre sources lumineuses (R, V, B, S) sont réparties en losange.

2. Ensemble (2) selon la revendication 1 **caractérisé par le fait que**, lesdites sources lumineuses (R, V, B, S) sont des diodes électroluminescentes.

3. Dispositif d'affichage comprenant une matrice (1) de pixels constituée d'une juxtaposition d'ensembles (2) selon l'une des revendications 1 ou 2.

## Patentansprüche

1. Anordnung aus (2) Lichtquellen zur Anzeige von mindestens einem Pixel innerhalb einer Matrix (1), bestehend einerseits aus drei Lichtquellen in den Farben Rot (R), Grün (V) und Blau (B), die durch Kombination in der Lage sind, das Lichtspektrum ganz oder teilweise zu reproduzieren, und andererseits einer zusätzlichen Lichtquelle (S) in der Farbe Weiß, die in der Lage ist, eine gleichmäßige weiße Farbe wiederherzustellen und das erzeugte Farbspektrum bei gleichzeitiger Steigerung der Helligkeit zu ergänzen, die vier Lichtquellen (R, V, B, S) sind so angeordnet, dass mindestens eine Quelle (R, V, B oder S) einer Anordnung (2) abstandsgleich zu den sechs übrigen Quellen der betreffenden Anordnung (2) sowie den Anordnungen (2) positioniert ist, die an diese angrenzen; dies ist dadurch charakterisiert, dass die genannten vier Lichtquellen (R, V, B, S) rautenförmig angeordnet sind.

2. Anordnung (2) gemäß Anspruch 1, die durch den Umstand charakterisiert ist, dass besagte Lichtquellen (R, V, B, S) Leuchtdioden sind.

3. Anzeigevorrichtung, bestehend aus einer Pixel-Matrix (1), die aus einer Aneinanderreihung der Anordnungen (2) gemäß einer der Ansprüche 1 oder 2 besteht.

## Claims

1. Series (2) of light sources to display at least one pixel inside a matrix (1), comprising, on the one hand, three light sources that are coloured red (R), green (G) and blue (B) capable of reproducing, through combination, all or part of the light spectrum, and on the other hand, an additional white light source (S) capable of reproducing a uniform white colour and completing the spectrum of reproduced colours while increasing brightness, with the four light sources (R, G, B and S) distributed so that at least one source (R, G, B, or S) in a series (2) is equidistant from six other sources belonging to said series (2), as well as the series (2) that are adjacent to it, **characterized by** the fact that the aforementioned light sources (R, G, B and S) are distributed in a rhomboid.

2. Series (2) according to claim 1 **characterized by** the fact that the aforementioned light sources (R, G, B, S) are light-emitting diodes.

3. Display device comprising a matrix (1) of pixels formed by a combination of adjacent series (2) according to one of claims 1 or 2.
